(19)

**Europäisches Patentamt**

**European Patent Office**

**Office européen des brevets**

(11) **EP 4 456 461 A1**

(12) **EUROPEAN PATENT APPLICATION**

(43) Date of publication:
**30.10.2024 Bulletin 2024/44**

(21) Application number: **24171272.8**

(22) Date of filing: **19.04.2024**

(51) International Patent Classification (IPC):
*H04L 1/00* (2006.01)       *H03M 13/00* (2006.01)
*G06N 3/045* (2023.01)       *G06N 3/0464* (2023.01)
*H04L 5/00* (2006.01)       *H04L 27/32* (2006.01)
*G06T 9/00* (2006.01)

(52) Cooperative Patent Classification (CPC):
**H04L 1/0025; G06N 3/045; G06N 3/0464;**
**H03M 13/6312; H03M 13/6597; H04L 1/0009;**
**H04L 1/004; H04L 1/0075;** G06T 9/002;
G06V 10/70; H04L 5/0048

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **25.04.2023 FI 20235453**

(71) Applicant: **Nokia Solutions and Networks Oy**
**02610 Espoo (FI)**

(72) Inventor: **LIAO, Qi**
**Ingolstadt (DE)**

(74) Representative: **Nokia EPO representatives**
**Nokia Technologies Oy**
**Karakaari 7**
**02610 Espoo (FI)**

(54) **MAPPING OF IMAGE DATA AND MOTION SENSOR DATA INTO MODULATION SYMBOLS FOR REMOTE LOCALIZATION SERVICES**

(57)      Disclosed is a method comprising obtaining first input data, that is image-based input data, and second input data, that is sensor-based input data, providing the first input data and the second input data to an encoder, wherein the encoder uses a machine learning model for mapping the first and second input data to encoded modulation symbols, adding a reference signal to the encoded modulation symbols, allocating transmission time interval resource units to the encoded modulation symbols with the reference signal, and transmitting the symbols with the refence signal to a transmission channel.

FIG. 3

**EP 4 456 461 A1**

## Description

### Field

The following exemplary embodiments relate to wireless communication and providing more effective communication using an end-to-end approach.

### Background

Wireless communication networks, such as cellular communication networks, may provide or facilitate various services. For example, for information that is transmitted and then received over a communication channel, services may be provided based on the received information. Alternatively, if the service is not directly provided by a wireless communication network, the wireless communication network may facilitate such a service by enabling communication with an application that provides the service. Communication may be understood to comprise information exchange between the application and an end user. An example of a service is localization, which may be understood as determining a location and, additionally or alternatively, also orientation. Localization may be provided directly by the wireless communication service. Additionally, or alternatively, in some example embodiments, localization may be a service that is provided by one or more localization applications. The one or more applications may then work together with the wireless communication network to enable provision localization services to end users. For such a service, there may be a great amount of information that is to be transmitted and thus, it is beneficial to optimize the communication required for providing and obtaining various services.

### Brief Description

The scope of protection sought for various embodiments of the invention is set out by the independent claims. The exemplary embodiments and features, if any, described in this specification that do not fall under the scope of the independent claims are to be interpreted as examples useful for understanding various embodiments of the invention.

According to a first aspect there is provided an apparatus comprising means for performing: obtaining first input data, that is image-based input data, and second input data, that is sensor-based input data, providing the first input data and the second input data to an encoder, wherein the encoder uses a machine learning model for mapping the first and second input data to encoded modulation symbols, adding a reference signal to the encoded modulation symbols, allocating transmission time interval resource units to the encoded modulation symbols with the reference signal, and transmitting the symbols with the refence signal to a transmission channel.

In some example embodiments according to the first aspect, the means comprises at least one processor, and at least one memory storing instructions that, when executed by the at least one processor, to cause the performance of the apparatus.

According to a second aspect there is provided an apparatus comprising at least one processor, and at least one memory storing instructions that, when executed by the at least one processor, to cause the apparatus at least to: obtain first input data, that is image-based input data, and second input data, that is sensor-based input data, provide the first input data and the second input data to an encoder, wherein the encoder uses a machine learning model for mapping the first and second input data to encoded modulation symbols, add a reference signal to the encoded modulation symbols, allocate transmission time interval resource units to the encoded modulation symbols with the reference signal, and transmit the symbols with the refence signal to a transmission channel.

According to a third aspect there is provided a method comprising: obtaining first input data, that is image-based input data, and second input data, that is sensor-based input data, providing the first input data and the second input data to an encoder, wherein the encoder uses a machine learning model for mapping the first and second input data to encoded modulation symbols, adding a reference signal to the encoded modulation symbols, allocating transmission time interval resource units to the encoded modulation symbols with the reference signal, and transmitting the symbols with the refence signal to a transmission channel.

In some example embodiment according to the third aspect the method is a computer implemented method.

According to a fourth aspect there is provided a computer program comprising instructions which, when executed by an apparatus, cause the apparatus to perform at least the following: obtain first input data, that is image-based input data, and second input data, that is sensor-based input data, provide the first input data and the second input data to an encoder, wherein the encoder uses a machine learning model for mapping the first and second input data to encoded modulation symbols, add a reference signal to the encoded modulation symbols, allocate transmission time interval resource units to the encoded modulation symbols with the reference signal, and transmit the symbols with the refence signal to a transmission channel.

According to a fifth aspect there is provided a computer program comprising instructions stored thereon for

2

performing at least the following: obtaining first input data, that is image-based input data, and second input data, that is sensor-based input data, providing the first input data and the second input data to an encoder, wherein the encoder uses a machine learning model for mapping the first and second input data to encoded modulation symbols, adding a reference signal to the encoded modulation symbols, allocating transmission time interval resource units to the encoded modulation symbols with the reference signal, and transmitting the symbols with the refence signal to a transmission channel.

According to a sixth aspect there is provided a non-transitory computer readable medium comprising program instructions that, when executed by an apparatus, cause the apparatus to perform at least the following: obtain first input data, that is image-based input data, and second input data, that is sensor-based input data, provide the first input data and the second input data to an encoder, wherein the encoder uses a machine learning model for mapping the first and second input data to encoded modulation symbols, add a reference signal to the encoded modulation symbols, allocate transmission time interval resource units to the encoded modulation symbols with the reference signal, and transmit the symbols with the refence signal to a transmission channel.

According to a seventh aspect there is provided a non-transitory computer readable medium comprising program instructions stored thereon for performing at least the following: obtaining first input data, that is image-based input data, and second input data, that is sensor-based input data, providing the first input data and the second input data to an encoder, wherein the encoder uses a machine learning model for mapping the first and second input data to encoded modulation symbols, adding a reference signal to the encoded modulation symbols, allocating transmission time interval resource units to the encoded modulation symbols with the reference signal, and transmitting the symbols with the refence signal to a transmission channel.

According to an eighth aspect there is provided a computer readable medium comprising program instructions that, when executed by an apparatus, cause the apparatus to perform at least the following: obtain first input data, that is image-based input data, and second input data, that is sensor-based input data, provide the first input data and the second input data to an encoder, wherein the encoder uses a machine learning model for mapping the first and second input data to encoded modulation symbols, add a reference signal to the encoded modulation symbols, allocate transmission time interval resource units to the encoded modulation symbols with the reference signal, and transmit the symbols with the refence signal to a transmission channel.

According to a ninth aspect there is provided a computer readable medium comprising program instructions stored thereon for performing at least the following: obtaining first input data, that is image-based input data, and second input data, that is sensor-based input data, providing the first input data and the second input data to an encoder, wherein the encoder uses a machine learning model for mapping the first and second input data to encoded modulation symbols, adding a reference signal to the encoded modulation symbols, allocating transmission time interval resource units to the encoded modulation symbols with the reference signal, and transmitting the symbols with the refence signal to a transmission channel.

According to a tenth aspect there is provided an apparatus comprising means for performing: receiving, using a channel, symbols with a reference signal, based on detecting the reference signal, bypassing physical layer decoding and demodulation, providing the symbols with the reference signal to a decoder, and obtaining an estimation of a location based on an output of the decoder.

In some example embodiments according to the tenth aspect, the means comprises at least one processor, and at least one memory storing instructions that, when executed by the at least one processor, to cause the performance of the apparatus.

According to an eleventh aspect there is provided an apparatus comprising at least one processor, and at least one memory storing instructions that, when executed by the at least one processor, to cause the apparatus at least to: receive, using a channel, symbols with a reference signal, based on detecting the reference signal, bypass physical layer decoding and demodulation, provide the symbols with the reference signal to a decoder, and obtain an estimation of a location based on an output of the decoder.

According to a twelfth aspect there is provided a method comprising: receiving, using a channel, symbols with a reference signal, based on detecting the reference signal, bypassing physical layer decoding and demodulation, providing the symbols with the reference signal to a decoder, and obtaining an estimation of a location based on an output of the decoder.

In some example embodiment according to the twelfth aspect the method is a computer implemented method.

According to a thirteenth aspect there is provided a computer program comprising instructions which, when executed by an apparatus, cause the apparatus to perform at least the following: receive, using a channel, symbols with a reference signal, based on detecting the reference signal, bypass physical layer decoding and demodulation, provide the symbols with the reference signal to a decoder, and obtain an estimation of a location based on an output of the decoder.

According to a fourteenth aspect there is provided a computer program comprising instructions stored thereon for performing at least the following: receiving, using a channel, symbols with a reference signal, based on detecting the reference signal, bypassing physical layer decoding and demodulation, providing the symbols with the reference signal to a decoder, and obtaining an estimation of a location based on an output of the decoder.

According to a fifteenth aspect there is provided a non-transitory computer readable medium comprising program instructions that, when executed by an apparatus, cause the apparatus to perform at least the following: receive, using a channel, symbols with a reference signal, based on detecting the reference signal, bypass physical layer decoding and demodulation, provide the symbols with the reference signal to a decoder, and obtain an estimation of a location based on an output of the decoder.

According to a sixteenth aspect there is provided a non-transitory computer readable medium comprising program instructions stored thereon for performing at least the following: receiving, using a channel, symbols with a reference signal, based on detecting the reference signal, bypassing physical layer decoding and demodulation, providing the symbols with the reference signal to a decoder, and obtaining an estimation of a location based on an output of the decoder.

According to a seventeenth aspect there is provided a computer readable medium comprising program instructions that, when executed by an apparatus, cause the apparatus to perform at least the following: receive, using a channel, symbols with a reference signal, based on detecting the reference signal, bypass physical layer decoding and demodulation, provide the symbols with the reference signal to a decoder, and obtain an estimation of a location based on an output of the decoder.

According to an eighteenth aspect there is provided a computer readable medium comprising program instructions stored thereon for performing at least the following: receiving, using a channel, symbols with a reference signal, based on detecting the reference signal, bypassing physical layer decoding and demodulation, providing the symbols with the reference signal to a decoder, and obtaining an estimation of a location based on an output of the decoder.

**List of Drawings**

In the following, the invention will be described in greater detail with reference to the embodiments and the accompanying drawings, in which

FIG. 1 illustrates an exemplary embodiment of a radio access network.
FIG. 2A illustrates an example embodiment of a visual localization service that utilizes an effective communication solution.
FIG. 2B illustrates an example embodiment of an architecture of an encoder.
FIG. 2C illustrates an example embodiment of an architecture of an decoder.
FIG. 2D illustrates an example embodiment in which an effective communication system comprises feature-based visual localization.
FIG. 2E illustrates an example embodiment of a decoder that can be used in the feature-based visual localization.
FIG. 3 illustrates a signalling chart according to an example embodiment.
FIG. 4 illustrates an example of an adaptive communication solution.
FIG. 5 illustrates an example of a communication system.
FIG. 6 and FIG. 7 illustrate example embodiments of an apparatus.

**Description of Embodiments**

The following embodiments are exemplifying. Although the specification may refer to "an", "one", or "some" embodiment(s) in several locations of the text, this does not necessarily mean that each reference is made to the same embodiment(s), or that a particular feature only applies to a single embodiment. Single features of different embodiments may also be combined to provide other embodiments.

As used in this application, the term 'circuitry' refers to all of the following: (a) hardware-only circuit implementations, such as implementations in only analog and/or digital circuitry, and (b) combinations of circuits and software (and/or firmware), such as (as applicable): (i) a combination of processor(s) or (ii) portions of processor(s)/software including digital signal processor(s), software, and memory(ies) that work together to cause an apparatus to perform various functions, and (c) circuits, such as a microprocessor(s) or a portion of a microprocessor(s), that require software or firmware for operation, even if the software or firmware is not physically present. This definition of 'circuitry' applies to all uses of this term in this application. As a further example, as used in this application, the term 'circuitry' would also cover an implementation of merely a processor (or multiple processors) or a portion of a processor and its (or their) accompanying software and/or firmware. The term 'circuitry' would also cover, for example and if applicable to the particular element, a baseband integrated circuit or applications processor integrated circuit for a mobile phone or a similar integrated circuit in a server, a cellular network device, or another network device. The above-described embodiments of the circuitry may also be considered as embodiments that provide means for carrying out the embodiments of the methods or processes described in this document.

The techniques and methods described herein may be implemented by various means. For example, these techniques may be implemented in hardware (one or more devices), firmware (one or more devices), software (one or more modules), or combinations thereof. For a hardware implementation, the apparatus(es) of embodiments may be implemented within one or more application-specific integrated circuits (ASICs), digital signal processors (DSPs), digital signal processing devices (DSPDs), programmable logic devices (PLDs), field programmable gate arrays (FPGAs), graphics processing units (GPUs), processors, controllers, micro-controllers, microprocessors, other electronic units designed to perform the functions described herein, or a combination thereof. For firmware or software, the implementation can be carried out through modules of at least one chipset (e.g. procedures, functions, and so on) that perform the functions described herein. The software codes may be stored in a memory unit and executed by processors. The memory unit may be implemented within the processor or externally to the processor. In the latter case, it can be communicatively coupled to the processor via any suitable means. Additionally, the components of the systems described herein may be rearranged and/or complemented by additional components in order to facilitate the achievements of the various aspects, etc., described with regard thereto, and they are not limited to the precise configurations set forth in the given figures, as will be appreciated by one skilled in the art.

For transmitting information, the purpose of the communication may be ignored and the focus may be on merely on transmitting the information from the transmitter to one or more recipients. Yet, use cases for communications are envisaged to become more specific and customized, which may lead to the volume of data to be communicated to become larger and larger. Such use cases are envisaged for example for 6G networks, and may comprise for example metaverse and holograms. However, there may be redundant information generated during the processes involved in such use cases.

For communication, there is thus the technical aspect that is regarding having a reliable communication for the data provided by for example a localization application, and the communications system as such may be considered as irrelevant to the goal of the application. And, vice versa, the application's computing (e.g., processing of the collected data and feature extraction) and controlling (e.g., predicting the position and orientation based on the features) functions may be independent of the communications channel.

Yet, the communication also has a semantic aspect included in it. For example, the semantic aspect may be about reliably transmitting and receiving the most informative data for the localization task, e.g., dynamic allocation of the communication resource (e.g., bandwidth, constellation size, codelength, power, ...) depending on the semantic information comprised in the data. Additionally, effectiveness may be an aspect included in the communication. Effectiveness may be about instead of using communication quality of service as performance metric, the communication system shares the same performance metric as the application, i.e., the accuracy of the estimated location and the end-to-end service latency. The transmitted and received analog waveform and the complex-valued symbols should be designed to improve the accuracy of localization task.

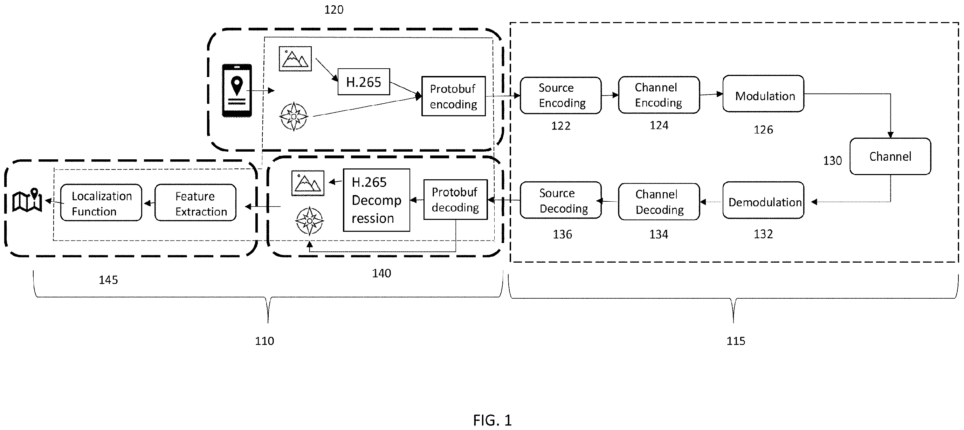

FIG. 1 illustrates an example embodiment of a technical aspect included in communication. In this example embodiment, the use case is such that machine learning is utilized for visual and sensor -based localization. To achieve such a solution, there is a mobile device, such as a mobile phone, that collects information using its sensors and for example camera and motion sensors. The mobile device may also be referred to as a user equipment or a terminal device and it may be any other suitable mobile device than a mobile phone as well. For example, a laptop or a tablet computer or even a vehicle. To use applications that provide a service for localization for example, the information relevant to the service, on the side of the application, may be part of a control system referred to as CTRL. CTRL 110 collects measurements from different sensors, such as video streaming (or images) and inertial measurement unit (IMU) and these measurements may be understood as input 120. The input may then be transmitted using a communication system referred to as COMM 115. The CTRL 110 uses the COMM 115 to reliably transmit and receive the information, that is in this example embodiment binary data, that it provides. The COMM 115 then follows the process of source encoding 122 the received binary data, then performing the channel encoding 124 after which it performs the digital modulation 126. After the modulation, the received data is transmitted over the channel to a receiver that then performs demodulation 132, channel decoding 134 and source decoding 136. After this, the exact data that was received by the COMM 115 is provided to the CTRL 110.

In this example embodiment, as the CTRL 110 and the COMM 115 function in a manner that is independent from each other, it may lead to a situation in which the CTRL 110 collects more information than needed to achieve the goal that may be for example that of estimating the location and orientation. This causes extra computational cost to compress the data (e.g., codec for video streaming) such that the amount of the transmitted data can be reduced to save the communication cost. On the other hand, the original messages or extracted features from CTRL 110 are to be first transformed into binary data (in bits), then encoded into symbols, and further translated into analog waveforms to form the actual transmitted signal for COMM 115. Then, the receiver must undo all these translations to decode the message. All these conversions and transformations of the information in many forms, including analog features, bits, symbols, and waveforms, are designed to improve the communication quality, independently from the intention of CTRL 115. Also, the COMM 115 may further introduce redundancy into the original information provided by CTRL 110 through channel coding and modulation to compensate for channel loss.

Thus, the effectiveness of the communication is terms of an end-to-end approach is also of interest and how it could be improved. For example, for an end-to-end localization service, it would be beneficial to allow joint optimization of CTRL 110 and COMM 115 such that the received meaning helps to achieve accurate localization.

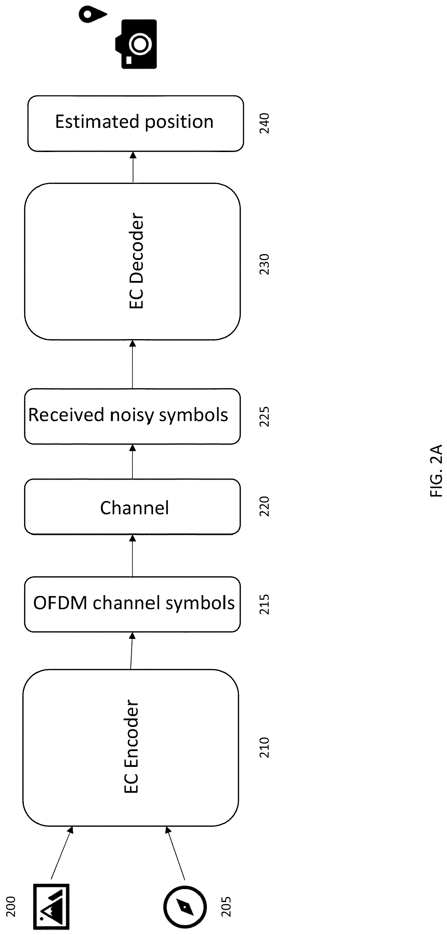

FIG. 2A illustrates an example embodiment of a visual localization service that utilizes effective communication (EC) solution that allows to jointly train optimizing CTRL and COMM to achieve their common goal, which in this example embodiment is accurate localization and low end-to-end service latency. It is to be noted that the solution of this example embodiment can be applied for both feature-based visual localization and end-to-end visual localization. It is also to be noted that the information may be transmitted from one device and received by another device. Thus, even though the handling of the information, in other words the CTRL of the system is illustrated as one entity, there may be two different devices involved, one transmitting and the other receiving the data that is transmitted. Also, the COMM is illustrated as one entity, but it is to be noted that there may be two different devices involved. For example, the receiving device may be another terminal device, or it may be an access node or any other suitable network device or a group of devices. In this example embodiment, input data is obtained, and the input data comprises images 200 and also sensor-based information 205, for example, motion sensor-based information, which is additional information to the images 200, which may also be referred to as image-based input. The input 200 and input 205 are then provided to an encoder 210, which in this example embodiment is an EC encoder. The encoder 210 is on the side of the transmitted and in this example embodiment, the encoder 210 is trained together with the corresponding decoder 230 on the receiver side. The decoder 230 is in this example embodiment an EC decoder. Thus, the encoder 210 and decoder 230 utilize machine learning and may be trained together. In this example embodiment, the training is performed towards a goal of accurate estimation of the location. The location may comprise both 3D position and 3D orientation (or 4D quaternion). At the transmitter, the encoder 210 directly maps input data 200 and 205 to B OFDM complex-valued symbols and transmit over B subcarrier-transmission time interval (TTI) resource units. Correspondingly, at the receiver side, a decoder 230 comprises a trained machine learning model for mapping the received channel symbols to the direct output of the visual localization task. Such a task may be for example estimating location for end-to-end visual localization, or determining the key-points and descriptors for feature-base visual localization. It is to be noted that the localization may be understood as determining a location.

Thus, in this example embodiment, the encoder 210 provides as an output the OFDM symbols 215 that are transmitted to the channel 220 and the receiver then receives the transmitted OFDM symbols 230 and provides them for decoding to the decoder 230. The decoder thus provides an output 240 that is the estimated location. It is to be noted that although OFDM is used in this example embodiment, any other suitable modulation technique could also be used.

Thus, the localization service may be jointly performed by enabling coordination between CTRL and COMM using a process that is herein referred to as an EC process. The process may utilize a reference signal, that is herein referred to as an EC reference signal, which is added to the symbols encoded by an EC encoder. This allows a COMM to trigger the EC communication and bypass any other coding and modulation protocols. To achieve this, the EC encoder and decoder are to be channel-aware adaptive encoder and decoder. Their dimensions of outputs (for encoders) and inputs (for decoders) are thus to be scalable based on the channel quality. This is because when there is more noise in the channel, it is desirable to map the image and side information to a higher dimension of the symbols, which requires more communications resources, to gain protection against corrupted transmission signals. Thus, there are more features to be extracted for the localization task. The adaptive EC encoders and decoders can be considered as a native way to integrate the adaptive feature extraction and adaptive modulation and coding.

On the CTRL side, which may also be considered as computer vision community, there may be two classes of visual localization techniques: feature-based visual localization and end-to-end visual localization, as mentioned previously. The feature-based visual localization comprises detecting, describing, and matching features between images, then applying visual odometry techniques for localization. Localization thus comprises determining the location, which is a geographical position. The localization may also comprise determining an orientation of the location in the image that is used for determining the location. A benefit with a feature-based visual localization is that it may be applicable to different environments.

In an end-to-end visual localization a neural network may be trained to determine a location based on input data. Thus, when an image and other related data, such as sensor-based data obtained from a mobile device, or from any other suitable computing device, are provided as an input to the trained neural network, the output from the neural network is the estimated location. A benefit with an end-to-end system is that interference time may be kept short.

Both of the visual localization techniques may have their applicable use cases, e.g., feature-based may be more suitable for an outdoor scenario, while the end-to-end technique may be more suitable for an indoor industrial environment. Both of these techniques may be used with an EC solution.

Looking at FIG. 2A now in more detail, in the example embodiment of FIG. 2A, the encoder 210, which resides in the side of the transmitted, receives as its input the image data 200, which may be an image or a video stream or a combination of both. Along with the image-based input data, there is additional input data, which in this example embodiment is the sensor-based input data 205, which in this example embodiment comprises channel feedback in addition to measurements from a motion sensor. Optionally, the image-based data 205 may be resized before it is provided to the trained machine learning model that is comprised in the encoder 210. In this example embodiment the trained ML model is a convolutional neural network (CNN) backbone such as ResNet50 or MobileNetV2, or some extracted layers of the pretrained backbone model, while the side information input is passed through multiple fully connected (FC) layers. It is to be noted that the extracted layers may be understood as a ML model that is a partial ML model as the partial ML model comprises a subset of layers, that is, the extracted layers. A partial ML model may have a benefit of providing accurate estimation of a location while also improving end-to-end latency. Then, the output of CNN and FC layers are concatenated and followed with more FC layers. The linear activated output directly returns the complex-value symbols, in this example embodiment OFDM channel symbols 215, to be transmitted on the channel 220. For example, a 2B-dim output can be the real and imaginary values of the B complex-valued symbols. An alternative of the output can be the phase and amplitude of the symbol to transmit over the OFDM subcarriers. For a fixed size of B symbols, there can be an allocation of $B$ units of subcarrier·TTI to transmit, e.g., $B$ subcarriers and 1 TTI.

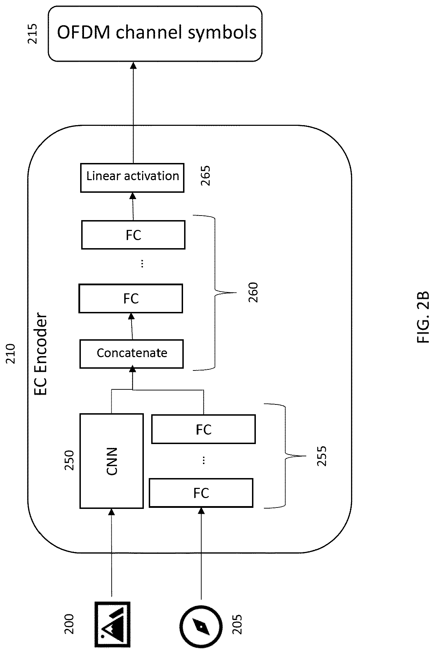

FIG. 2B illustrates an example embodiment of an architecture of the encoder 210, which is an EC encoder. The encoder 210 receives the image-based input 200 and provides it to the trained CNN 250 backbone which is a feature-extracting network that processes the image-based input 200 into a feature representation. Alternatively, any other suitable trained machine learning model or partial ML model comprising a subset of layers of the ML model, capable of feature-extraction may be used. The additional input 205, which may be sensor-based input data, is provided to a plurality of fully connected layers 255 of the CNN. The output of the CNN backbone 250 and the plurality of the fully connected layers 255 is then concatenated and provided to another set of FC layers 260. The output of the other set of FC layers 260 is then provided to linear activation 265 that provides the OFDM symbols 215 for the channel. If the output dimension $B$ is large, the OFDM symbols 215 over a block of OFDM resources, i.e., over $T$ TTIs and $B'$ subcarriers such that $B = TB'$.

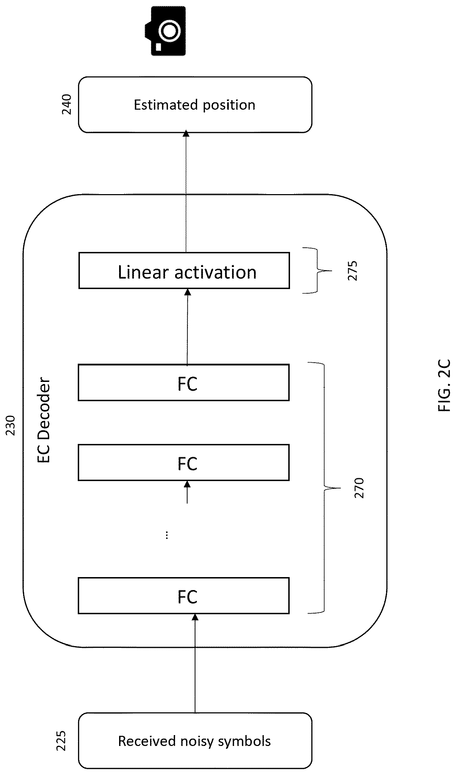

FIG. 2C illustrates an example embodiment of an architecture of the decoder 230, that is an EC decoder. The received symbols 225, that are in this example embodiment OFDM symbols, are noisy symbols as the channel is noisy. The received symbols 225 are then provided to a set of FCs 270. The output of the FCs is then provided for linear activation 275 after which the output 240 is obtained from the decoder 230. The output 240 is the estimated location. The decoder 230 may be for example a multi-layer perceptron (MLP), with the B received symbols as the 2B-dim input (real and imaginary values, or phase and amplitude) and the estimated location as the output. The output location may comprise the position $l(t) \in R^3$ and the orientation, either in the form of rotation angles $o(t) \in R^3$ or quaternion $q(t) \in R^4$. The position and the orientation may those of the mobile device from which the input data 200 and 205 are obtained.

In this example embodiment, the encoder 210 and the decoder 230 are based on machine learning and they may be trained together, in other words, they may be jointly trained, with a common loss function based on the localization accuracy. Different loss functions may be considered. For example, a weighted sum of the distance between the estimated position l and the ground truth of position l* and the distance between the estimated quaternion $\frac{q}{\|q\|}$ (quaternion subjected to unit length) and the ground truth quaternion q*, respectively. In below equations (1) and (2) there are two examples of the loss function. In (1), the Euclidean distance is used for both the position and quaternion. In (2), the Euclidean distance is used for the position, while a function to reflect the angle difference $\angle(\cdot)$ for the quaternion.

$$L(\mathrm{p}, \mathrm{p}^*) = (1 - \beta)\|\mathrm{l} - \mathrm{l}^*\| + \beta \left\| \mathrm{q}^* - \frac{\mathrm{q}}{\|\mathrm{q}\|} \right\| \qquad (1)$$

$$L(\mathrm{p}, \mathrm{p}^*) = (1 - \beta)\|\mathrm{l} - \mathrm{l}^*\| + \beta \angle(\mathrm{q}, \mathrm{q}^*) \qquad (2)$$

In the equations (1) and (2) the angle loss function yields $\angle(\mathrm{q}, \mathrm{q}^*) = 1 - \left| \mathrm{q}^* \cdot \frac{\mathrm{q}}{\|\mathrm{q}\|} \right|$.

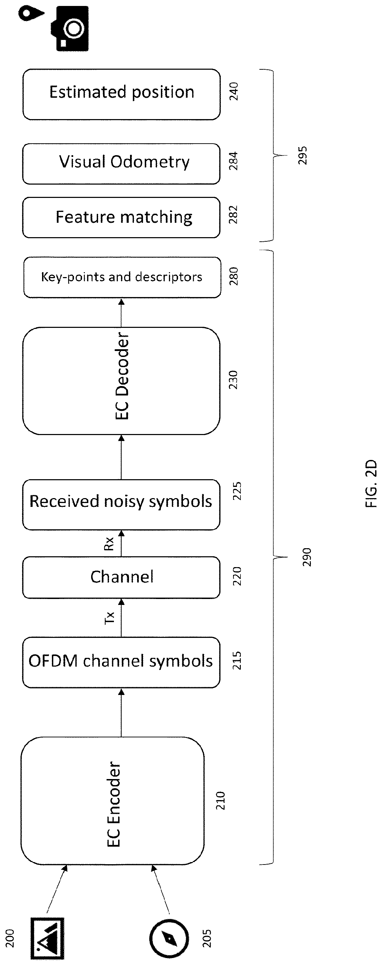

FIG. 2D illustrates an example embodiment in which the EC system comprises feature-based visual localization instead of the end-to-end visual localization. Thus, this example embodiment is a further development of FIG. 2A and different than the further development to the FIG. 2A introduced in the example embodiments of FIG. 2B and 2C. In this example embodiment, there is joint CTRL and COMM optimization 290, which is then applied to derive interested keypoints and their descriptors 280 from the output of the encoder 230, but not the location estimation directly. The localization estimation is performed by the independent CTRL steps 295 of feature matching 282 and visual odometry 284, e. g.,

Random Sample Consensus (RANSAC) or Direct Linear Transformation (DLT) estimators. Finally, the estimated position 240 is obtained.

Yet, also in this example embodiment, the encoder 230 may correspond to the encoder 230 of the example embodiment FIG. 2B. A possible modification is to introduce max-pooling layers before the CNN 250 for the image input to down sample the image-based input 200.

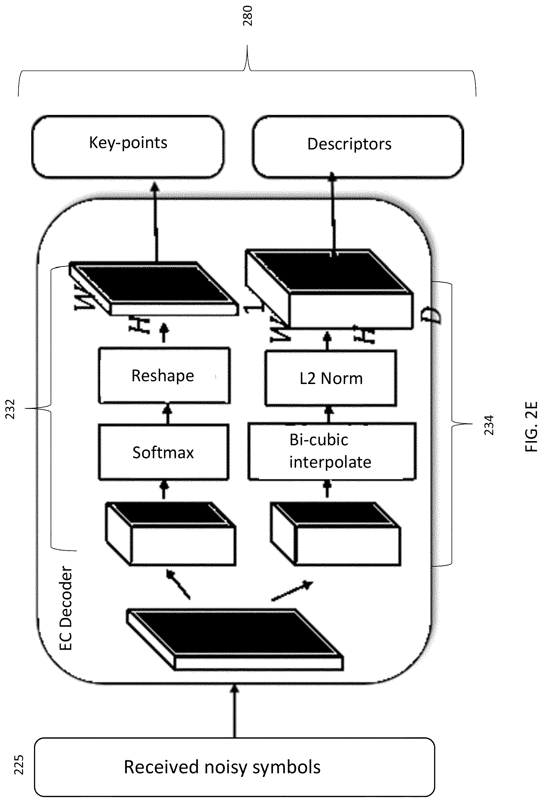

FIG. 2E illustrates an example embodiment of a decoder that can be used in the feature-based visual localization. In this example embodiment, the decoder 230 is provided with the received symbols 225 as its input. It reshapes them, and passes them to two separate CNNs, 232 and 234. After a channel-wise softmax, the first CNN 232 is then reshaped to $[0, 1]^{W \times H}$ where $W$ is the width of the input image and $H$ is the height of the image. The $(w,h)$-th entry corresponds to the probability that this pixel is identified as a key-point. The second CNN 234, as the descriptor decoder, performs bi-cubic interpolation and then L2-normalizes the activation to be unit length. The output of the descriptor decoder is a matrix in $\mathbb{R}^{W \times H \times D}$ where $D$ is the dimension of the feature descriptor. Such an architecture can coop with arbitrary number of decoded key-points, because it outputs the significance and the descriptor for each pixel for the considered image. An alternative approach to reduce the complexity (by sacrificing the flexible number of decoded key-points) is to output a fixed number of the key-points and their corresponding visual descriptors 280. In this case, MLP may be used as the decoder 230.

The encoder 210 and decoder 230 are jointly trained, in this example embodiment, with the loss function based on the localization accuracy. The loss functions may be for example the equations (1) or (2) described above.

Thus, the CTRL and COMM may coordinate to provide the localization service with a trained EC encoder and a trained EC decoder. The localization service provided using an EC system such as described above may provide localization in real time, e. g., automated guided vehicle (AGV) real-time localization that generates multiple queries per second for each AGV, or non-real-time, e. g., location identification which generates sporadic queries.

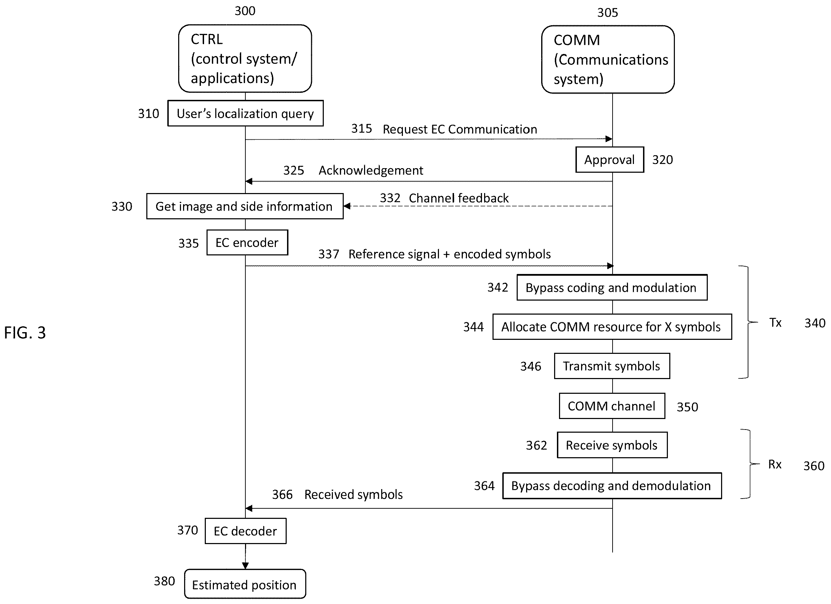

FIG. 3 illustrates a signalling chart according to an example embodiment. In this example embodiment, the process for an end-to-end visual localization is described. In this example embodiment there is a CTRL 300 and a COMM 305. The CTRL receives a localization query 310 from a user, which may be understood as a terminal device. After receiving the localization query 310, the CTRL 300, which may be a localization service application, transmits a request 315 to COMM 305 to initiate an EC communication that bypasses physical layer coding and modulation, and request the resource for X symbols per query for activating the EC. The number X=B+H is the sum of the dimension of the EC encoder's output B, and the number of symbols for the EC reference signal to indicate the activation of an EC communication, which is provided by the EC system. H may also be increased by adding the number of symbols for cyclic prefix (CP).

If COMM 305 approves 320 to activate EC system 320, it transmits an acknowledgement 325 to the CTRL 300. The CTRL 300 collects input 330 for the EC encoder 335. The input 330 may comprise image-based, visual information (e.g., image or video streaming), additional information such as sensor-based information like measurements (e.g., motion sensor measurements), and optionally the channel feedback 332 from COMM 305. Input information may also be understood as input data.

Using the EC encoder 335, CTRL 300 maps the input information to B complex-valued symbols. Then, an EC reference signal is added to the B symbols, and the joint signals 337 are provided to COMM 305 for transmission 340. It is also optional to add the CP to the joint signals 337. COMM 305 recognizes the EC reference signal, bypasses the conventional coding and modulation protocols 342, allocates communication resources for the X symbols 344 encoded for the query, and transmits the symbols 346. The symbols are delivered over a communication channel 350 and received by the receiver 360 as a noisy version of the transmitted symbols 362. Decoding and demodulation are then bypassed 364. The received symbols 366 are fed into the EC decoder 370 in CTRL 300 and decoded as the estimated location 380.

It is to be noted that if the process illustrated in the example embodiment of FIG. 3 was to be applied to the feature-based visual localization then the variation would be such that the EC decoder would provide the detected key-points and descriptors and then CTRL further uses the key-points and descriptors to estimate the localization with visual odometry-assisted approaches.

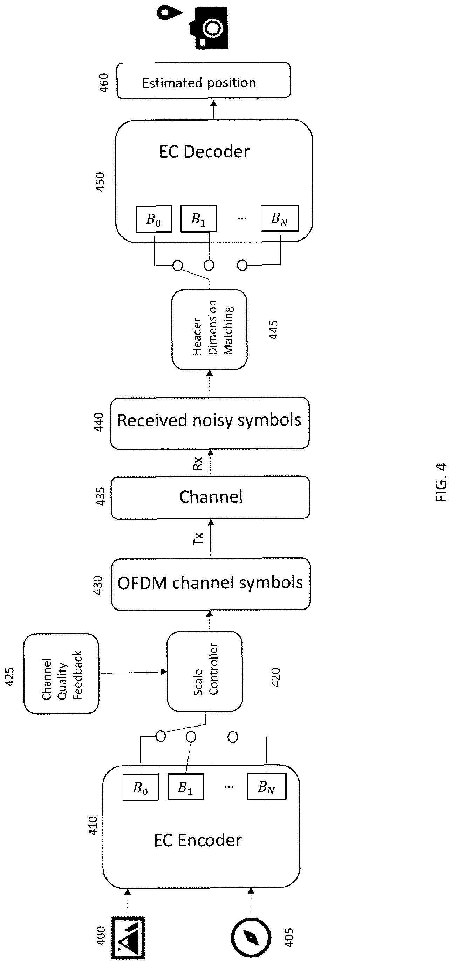

The EC communication solutions described above encode the input to a fixed size of the symbols, thus, the output of the EC encoder and the input of the EC decoder have a defined dimension $B$. However, for more efficient EC communication, scalable output and input dimensions for the EC encoder and decoder, respectively, may be allowed. Thus, there may be an adaptive EC solution, which selects different scale of the EC encoder and decoder and adjusts the length of the encoded symbols depending on the channel quality. FIG. 4 illustrates an example of an adaptive EC communication solution. In this example embodiment, image-based input 400 and additional, sensor-based input 405 is provided to an encoder 410, that is an EC encoder. The encoder 410 is a multi-scale encoder with multiple outputs and, correspondingly, there is also a multi-scale EC decoder 450 with multiple inputs. The output tails in the EC encoder and the input headers in the EC decoder are defined with different dimensions $B_0, ..., B_N$. Depending on the channel quality feedback 425, a scale controller 420 chooses a specific dimension of the encoded symbols 430 to transmit using the channel 435. Then, on the receiver side, depending on the received size of symbols, the receive symbols 440 may be fed to a matching head 445 of the decoder 450 to decode to obtain the estimated location 460.

It is to be noted that there may be two options to build the multi-scale EC encoder 410 and decoder 450. In the first option, a single model may be jointly trained with split output layers/tails for the encoder 410, and a single model with split headers in the decoder 450. E.g., when a scale $B_0$ is selected, the $B_0$-dimensional tail may be used to output the encoded symbols for transmission over the communication channel 435. Then, when $B_0$ symbols are received, $B_0$ may be matched with a proper header and zero padding to the other headers, and feed it as the input to the decoder 450. In the second option $B_N$ separate sub-models may be trained for different dimensions of the input/output for the encoder 410 and decoder 450, respectively. E.g., when a scale $B_0$ is selected, the sub-models with output and input dimension of $B_0$ to encode and decode, respectively, may be used.

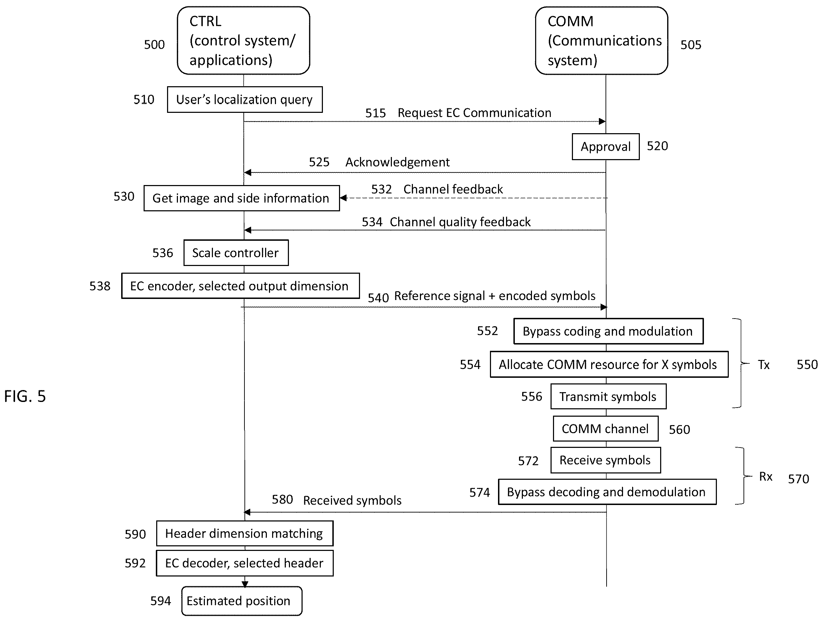

FIG. 5 illustrates another example embodiment of an EC communication system. In this example embodiment there is coordination between CTRL 500 and COMM 505, with channel-aware scalable encoder and decoder. The CTRL 500 first receives a localization query 510 from a user, which may be understood as a terminal device. The CTRL 500 the transmits a request 515 to the COMM 505 for EC communication. The COMM 505 then approves 520 the request that transmits an acknowledgement 525 to the CTRL 500. The CTRL then obtains the image-based input as well as additional input 530. Optionally, also channel feedback 532 may be obtained from the COMM 505. The CTRL 500 then receives channel quality feedback from the COMM 505 and scales the controller 536 based on the channel quality feedback information received. Next, an appropriate scale for the EC encoder is selected 538, in other words, the output dimensions are determined. Using the EC encoder 538, CTRL 500 maps the input information to the encoded symbols. Then, an EC reference signal is added to the encoded symbols, and the joint signals 540 are provided to COMM 505 for transmission 550. COMM 505 recognizes the EC reference signal, bypasses the conventional coding and modulation protocols 552, allocates communication resources for the X symbols 554 encoded for the query, and transmits the symbols 556. The symbols are delivered over a communication channel 560 and received by the receiver 570 as a noisy version of the transmitted symbols 572. Decoding and demodulation is then bypassed 574. The received symbols 580 are fed to header dimension matching 590 and then, EC decoder uses the selected header 592 to obtain the estimated location 595.

Embodiments described herein may be implemented in a communication system, such as in at least one of the following: Long Term Evolution (LTE), LTE-Advanced, a fifth generation (5G) mobile or cellular communication system, 5G-Advanced and/or 6G. The embodiments are not, however, restricted to the systems given as an example but a person skilled in the art may apply the solution to other communication systems provided with necessary properties.

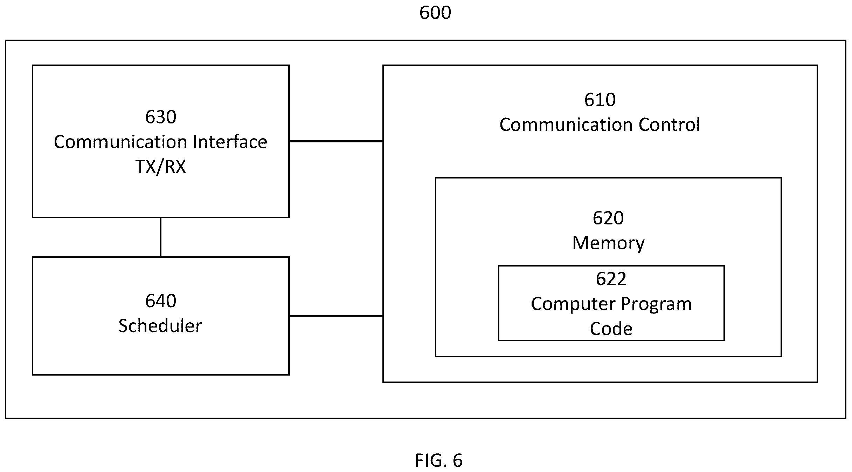

The apparatus 600 of FIG. 6 illustrates an example embodiment of an apparatus that may be an access node or be comprised in an access node such as a gNB, used in a wireless communication network that may utilize EC communication. The apparatus may be, for example, a circuitry or a chipset applicable to an access node to realize the described embodiments. The apparatus 600 may be an electronic device comprising one or more electronic circuitries. The apparatus 600 may comprise a communication control circuitry 610 such as at least one processor, and at least one memory 620 including a computer program code (software) 622 wherein the at least one memory and the computer program code (software) 622 are configured, with the at least one processor, to cause the apparatus 600 to carry out any one of the example embodiments of the access node described above.

The memory 620 may be implemented using any suitable data storage technology, such as semiconductor-based memory devices, flash memory, magnetic memory devices and systems, optical memory devices and systems, fixed memory and removable memory. The memory may comprise a configuration database for storing configuration data. For example, the configuration database may store current neighbour cell list, and, in some example embodiments, structures of the frames used in the detected neighbour cells.

The apparatus 600 may further comprise a communication interface 630 comprising hardware and/or software for realizing communication connectivity according to one or more communication protocols. The communication interface 630 may provide the apparatus with radio communication capabilities to communicate in the cellular communication system. The communication interface may, for example, provide a radio interface to terminal devices. The apparatus 600 may further comprise another interface towards a core network such as the network coordinator apparatus and/or to the access nodes of the cellular communication system. The apparatus 600 may further comprise a scheduler 640 that is configured to allocate resources.

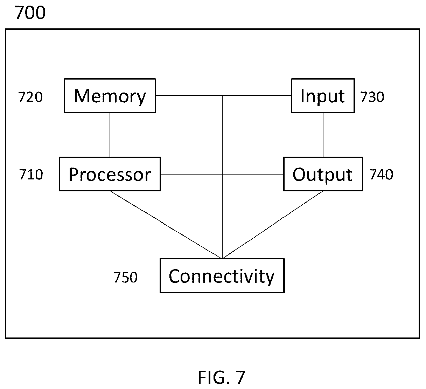

FIG. 7 illustrates an apparatus 700, which may be an apparatus such as, or comprised in, a user equipment, according to an example embodiment. The apparatus 700 comprises a processor 710. The processor 710 interprets computer program instructions and processes data. The processor 710 may comprise one or more programmable processors. The processor 710 may comprise programmable hardware with embedded firmware and may, alternatively or additionally, comprise one or more application specific integrated circuits, ASICs.

The processor 710 is coupled to a memory 720. The processor is configured to read and write data to and from the memory 720. The memory 720 may comprise one or more memory units. The memory units may be volatile or non-volatile. It is to be noted that in some example embodiments there may be one or more units of non-volatile memory and one or more units of volatile memory or, alternatively, one or more units of non-volatile memory, or, alternatively, one or more units of volatile memory. Volatile memory may be for example RAM, DRAM or SDRAM. Non-volatile memory may be for example ROM, PROM, EEPROM, flash memory, optical storage or magnetic storage. In general, memories may be referred to as non-transitory computer readable media. The memory 720 stores computer readable instructions that are execute by the processor 710. For example, non-volatile memory stores the computer readable instructions and the processor 710 executes the instructions using volatile memory for temporary storage of data and/or instructions.

The computer readable instructions may have been pre-stored to the memory 720 or, alternatively or additionally, they may be received, by the apparatus, via electromagnetic carrier signal and/or may be copied from a physical entity such as computer program product. Execution of the computer readable instructions causes the apparatus 700 to perform functionality described above.

In the context of this document, a "memory" or "computer-readable media" may be any non-transitory media or means that can contain, store, communicate, propagate or transport the instructions for use by or in connection with an instruction execution system, apparatus, or device, such as a computer.

The apparatus 700 further comprises, or is connected to, an input unit 730. The input unit 730 comprises one or more interfaces for receiving a user input. The one or more interfaces may comprise for example one or more motion and/or orientation sensors, one or more cameras, one or more accelerometers, one or more microphones, one or more buttons and one or more touch detection units. Further, the input unit 730 may comprise an interface to which external devices may connect to.

The apparatus 700 also comprises an output unit 740. The output unit comprises or is connected to one or more displays capable of rendering visual content such as a light emitting diode, LED, display, a liquid crystal display, LCD and a liquid crystal on silicon, LCoS, display. The output unit 740 further comprises one or more audio outputs. The one or more audio outputs may be for example loudspeakers or a set of headphones.

The apparatus 700 may further comprise a connectivity unit 750. The connectivity unit 750 enables wired and/or wireless connectivity to external networks. The connectivity unit 750 may comprise one or more antennas and one or more receivers that may be integrated to the apparatus 700 or the apparatus 700 may be connected to. The connectivity unit 750 may comprise an integrated circuit or a set of integrated circuits that provide the wireless communication capability for the apparatus 700. Alternatively, the wireless connectivity may be a hardwired application specific integrated circuit, ASIC.

It is to be noted that the apparatus 700 may further comprise various components not illustrated in the FIG. 7. The various components may be hardware component and/or software components.

Even though the invention has been described above with reference to examples according to the accompanying drawings, it is clear that the invention is not restricted thereto but can be modified in several ways within the scope of the appended claims. Therefore, all words and expressions should be interpreted broadly and they are intended to illustrate, not to restrict, the embodiment. It will be obvious to a person skilled in the art that, as technology advances, the inventive concept can be implemented in various ways. Further, it is clear to a person skilled in the art that the described embodiments may, but are not required to, be combined with other embodiments in various ways.

**Claims**

1. An apparatus comprising at least one processor, and at least one memory storing instructions that, when executed by the at least one processor, to cause the apparatus at least to:

   obtain first input data, that is image-based input data, and second input data, that is sensor-based input data;
   provide the first input data and the second input data to an encoder, wherein the encoder uses a machine learning model for mapping the first and second input data to encoded modulation symbols;
   add a reference signal to the encoded modulation symbols;
   allocate transmission time interval resource units to the encoded modulation symbols with the reference signal; and
   transmit the symbols with the refence signal to a transmission channel.

2. An apparatus according to claim 1, wherein the apparatus is further caused to bypass physical layer coding and modulation protocols before transmitting the encoded modulation symbols with the reference signal.

3. An apparatus according to claims 1 or 2, wherein the apparatus is further caused to receive channel quality feedback and determined, based on the channel quality feedback, determine dimensions of an output of the encoder.

4. An apparatus according to any previous claim, wherein the apparatus is further caused to receive a query for localization of a terminal device and request resources for communication that uses the reference signal before obtaining the first and the second input data.

5. An apparatus according to any previous claim, wherein the machine learning model is a convolutional neural network, or a partial machine learning model comprising a subset of layers of the convolutional neural network, and the first input data is provided to the backbone or to the subset of layers of the convolutional neural network, the second input is provided to a first plurality of fully connected layers, and the output of the backbone and the output of the first plurality of fully connected layers are concatenated and provided to a second plurality of fully connect layer, the output of which is provided to linear activation.

6. An apparatus according to any previous claim, wherein the machine learning model is for extracting features of the first input data.

7. An apparatus according to any previous claim, wherein the machine learning model is trained together with another machine learning model that is used by a decoder of a receive receiving the symbols with the reference signal.

8. An apparatus comprising at least one processor, and at least one memory storing instructions that, when executed by the at least one processor, to cause the apparatus at least to:

> receive, using a channel, symbols with a reference signal;
> based on detecting the reference signal, bypass physical layer decoding and demodulation;
> provide the symbols with the reference signal to a decoder; and
> obtain an estimation of a location based on an output of the decoder.

9. An apparatus according to claim 8, wherein the output of the decoder is the estimation of the location.

10. An apparatus according to claim 8, wherein the output of the decoder comprises key-points and descriptors for feature-based determination of the estimation of the location.

11. An apparatus according to any of claims 8 to 10, wherein dimensions of inputs of the decoder are determined based on channel quality feedback.

12. An apparatus according to any of claims 8 to 11, wherein the decoder uses at least one machine learning model that is trained together with another machine learning model comprised in an encoder that is for transmitting the received symbols.

13. An apparatus according to claim 12, wherein the decoder comprises two machine learning models that are convolutional neural networks.

14. A method comprising:

> obtaining first input data, that is image-based input data, and second input data, that is sensor-based input data;
> providing the first input data and the second input data to an encoder, wherein the encoder uses a machine learning model for mapping the first and second input data to encoded modulation symbols;
> adding a reference signal to the encoded modulation symbols;
> allocating transmission time interval resource units to the encoded modulation symbols with the reference signal; and
> transmitting the symbols with the refence signal to a transmission channel.

15. A computer readable medium comprising program instructions that, when executed by an apparatus, cause the apparatus to perform at least the following:

> obtain first input data, that is image-based input data, and second input data, that is sensor-based input data;
> provide the first input data and the second input data to an encoder, wherein the encoder uses a machine learning model for mapping the first and second input data to encoded modulation symbols;
> add a reference signal to the encoded modulation symbols;
> allocate transmission time interval resource units to the encoded modulation symbols with the reference signal; and

transmit the symbols with the refence signal to a transmission channel.

FIG. 1

FIG. 2A

FIG. 2B

FIG. 2C

200

205

EC Encoder
210

OFDM channel symbols
215

Tx

Channel
220

Rx

Received noisy symbols
225

EC Decoder
230

Key-points and descriptors
280

Feature matching
282

Visual Odometry
284

Estimated position
240

290

295

**FIG. 2D**

FIG. 2E

FIG. 3

FIG. 4

FIG. 5

600

610
Communication Control

620
Memory

622
Computer Program Code

630
Communication Interface
TX/RX

640
Scheduler

FIG. 6

700

FIG. 7

Europäisches
Patentamt
European
Patent Office
Office européen
des brevets

# EUROPEAN SEARCH REPORT

**Application Number**

EP 24 17 1272

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | YANG MINGYU ET AL: "Deep Joint Source Channel Coding for Wireless Image Transmission with OFDM", ICC 2021 - IEEE INTERNATIONAL CONFERENCE ON COMMUNICATIONS, IEEE, 14 June 2021 (2021-06-14), pages 1-6, XP033953731, DOI: 10.1109/ICC42927.2021.9500996 [retrieved on 2021-07-28] * the whole document * | 1-15 | INV. H04L1/00 H03M13/00 G06N3/045 G06N3/0464 ADD. H04L5/00 H04L27/32 G06T9/00 |
| X | WO 2021/181002 A1 (NOKIA SOLUTIONS & NETWORKS OY [FI]) 16 September 2021 (2021-09-16) * the whole document * | 8-13 | |
| A | HU TIANLUN ET AL: "Real-Time Camera Localization with Deep Learning and Sensor Fusion", ICC 2021 - IEEE INTERNATIONAL CONFERENCE ON COMMUNICATIONS, IEEE, 14 June 2021 (2021-06-14), pages 1-7, XP033953559, DOI: 10.1109/ICC42927.2021.9500770 [retrieved on 2021-07-28] * I. Introduction * * II. Problem Statement and Proposed Solution * * III. Experiment Setup and Dataset * | 1-15 | TECHNICAL FIELDS SEARCHED (IPC) H04L G06N H03M G01S G06T G06V |
| A | WO 2022/212253 A1 (IDAC HOLDINGS INC [US]) 6 October 2022 (2022-10-06) * paragraph [0071] - paragraph [0104] * * paragraph [0194] - paragraph [0270] * * figures 2A,2B,3 * | 1,2,8 | |

-/--

The present search report has been drawn up for all claims

| Place of search | Date of completion of the search | Examiner |
|---|---|---|
| Munich | 22 August 2024 | Gardella, Simone |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 24 17 1272

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2022/330036 A1 (AIT AOUDIA FAYCAL [FR] ET AL) 13 October 2022 (2022-10-13) * paragraph [0053] - paragraph [0070] * * figures 2-8 * ----- | 1,8,14, 15 | |

TECHNICAL FIELDS
SEARCHED     (IPC)

The present search report has been drawn up for all claims

| Place of search | Date of completion of the search | Examiner |
|---|---|---|
| Munich | 22 August 2024 | Gardella, Simone |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.....................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 17 1272

This annex lists the patent family members relating to the patent documents cited in the above-mentioned European search report.
The members are as contained in the European Patent Office EDP file on
The European Patent Office is in no way liable for these particulars which are merely given for the purpose of information.

22-08-2024

| Patent document cited in search report | | Publication date | Patent family member(s) | | Publication date |
|---|---|---|---|---|---|
| WO 2021181002 | A1 | 16-09-2021 | CN | 115462040 A | 09-12-2022 |
| | | | CN | 116601876 A | 15-08-2023 |
| | | | EP | 4118798 A1 | 18-01-2023 |
| | | | EP | 4226511 A1 | 16-08-2023 |
| | | | FI | 20205261 A1 | 13-09-2021 |
| | | | FI | 20205990 A1 | 13-09-2021 |
| | | | JP | 7511015 B2 | 04-07-2024 |
| | | | JP | 2023517681 A | 26-04-2023 |
| | | | US | 2023362042 A1 | 09-11-2023 |
| | | | US | 2023403182 A1 | 14-12-2023 |
| | | | WO | 2021181002 A1 | 16-09-2021 |
| | | | WO | 2022073752 A1 | 14-04-2022 |
| WO 2022212253 | A1 | 06-10-2022 | CN | 117280640 A | 22-12-2023 |
| | | | EP | 4315673 A1 | 07-02-2024 |
| | | | US | 2024187127 A1 | 06-06-2024 |
| | | | WO | 2022212253 A1 | 06-10-2022 |
| US 2022330036 | A1 | 13-10-2022 | CN | 115150238 A | 04-10-2022 |
| | | | EP | 4068164 A1 | 05-10-2022 |
| | | | US | 11483717 B1 | 25-10-2022 |

EPO FORM P0459

For more details about this annex : see Official Journal of the European Patent Office, No. 12/82